# EUROPEAN PATENT APPLICATION

(11) **EP 4 657 706 A1**
(43) Date of publication of application: **03.12.2025**
(21) Application number: 24852203.9
(22) Date of filing: 01.08.2024
(51) Int. Cl.: H02J 7/00, G01R 19/165, H01M 10/44, H01M 10/42

(54) **BATTERY MANAGEMENT APPARATUS AND OPERATING METHOD THEREOF**

(30) Priority: 07.08.2023 KR 20230102876
(71) Applicant: LG Energy Solution, Ltd., Seoul 07335 (KR)
(72) Inventor: JO, Yong Min, Daejeon 34122 (KR)
(74) Representative: Plasseraud IP
(86) International application number: PCT/KR2024/011345
(87) International publication number: WO 2025/033849

(57) **Abstract**

A battery management apparatus according to an embodiment disclosed herein includes an information obtaining unit configured to measure a cell current of each of a plurality of battery cells and a controller configured to calculate an available capacity of each of the plurality of battery cells, based on the cell current, extract a reference battery cell having a minimum available capacity among available capacities of the plurality of battery cells and set the minimum available capacity as a reference capacity, set a reference depth of discharge (DOD) that is a DOD value set in a random DOD range, calculate a first reference voltage corresponding to the reference DOD of the reference battery cell, and perform balancing on each of the plurality of battery cells based on the first reference voltage.

## Description

### [TECHNICAL FIELD]

### CROSS-REFERENCE TO RELATED APPLICATION

This application claims priority to and the benefit of Korean Patent Application No. 10-2023-0102876 filed in the Korean Intellectual Property Office on August 7, 2023, the entire content of which is incorporated herein by reference.

### TECHNICAL FIELD

Embodiments disclosed herein relate to a battery management apparatus and an operating method thereof.

### [BACKGROUND ART]

When a battery pack is used for a long time, the degree of aging and internal resistances of a plurality of battery cells may differ and a cell deviation may occur between a plurality of battery cells. In this case, the cell deviation may refer to a deviation of an available capacity (Ah) and a deviation of a cell voltage. As the cell deviation increases, over-charging or over-discharging may occur, such that the entire capacity of the battery pack may decrease and the life of the battery pack may be shortened.

To solve such a problem, a battery system performs cell balancing by reducing a deviation between cells. The battery system calculates a cell balancing current value based on an open circuit voltage (OCV) value and performs cell balancing during a balancing time calculated based on the balancing current value.

Meanwhile, when cell balancing is performed at a point corresponding to an SOC of 0 % or 100 % of a battery cell, an lower end or an upper end of the SOC of the battery cell may be repetitively used, accelerating degradation of the battery cell.

### [DISCLOSURE]

### [TECHNICAL PROBLEM]

Embodiments disclosed herein aim to provide a battery management apparatus and an operating method thereof in which balancing may be performed based on a capacity of each battery cell included in a plurality of battery cells.

Embodiments disclosed herein aim to provide a battery management apparatus and an operating method thereof in which a use frequency may be adjusted according to a cell voltage period of a battery cell.

Technical problems of the embodiments disclosed herein are not limited to the aforementioned technical problems, and other unmentioned technical problems would be clearly understood by those of ordinary skill in the art from the following description.

### [TECHNICAL SOLUTION]

A battery management apparatus according to an embodiment disclosed herein includes an information obtaining unit configured to measure a cell current of each of a plurality of battery cells and a controller configured to calculate an available capacity of each of the plurality of battery cells, based on the cell current, extract a reference battery cell having a minimum available capacity among available capacities of the plurality of battery cells and set the minimum available capacity as a reference capacity, set a reference depth of discharge (DOD) that is a DOD value set in a random DOD range, calculate a first reference voltage corresponding to the reference DOD of the reference battery cell, and perform balancing on each of the plurality of battery cells based on the first reference voltage.

According to an embodiment, the controller may be further configured to adjust a cell voltage of each of the plurality of battery cells such that a comparative voltage corresponding to the reference DOD of each of the plurality of battery cells corresponds to the first reference voltage.

According to an embodiment, the controller may be further configured to set an operating voltage range of each of the plurality of battery cells such that an operating capacity of each of the plurality of battery cells corresponds to the reference capacity.

According to an embodiment, the plurality of battery cells may include a first battery cell and a second battery cell having an available capacity that is different from an available capacity of the first battery cell, and an operating voltage range of the first battery cell may be different from an operating voltage range of the second battery cell.

According to an embodiment, the available capacity of the first battery cell may be less than the available capacity of the second battery cell, and the operating voltage range of the first battery cell may include the operating voltage range of the second battery cell.

According to an embodiment, the controller may be further configured to set a modified state of charge (SOC) of each of the plurality of battery cells, based on the operating voltage range of each of the plurality of battery cells.

According to an embodiment, an operating capacity of each of the plurality of battery cells, which corresponds to the operating voltage, may be the same as each other.

According to an embodiment, the controller may be further configured to perform balancing on each of the plurality of battery cells when a difference between a maximum available capacity and the minimum available capacity of the plurality of battery cells is greater than or equal to a preset value.

According to an embodiment, the reference DOD may be defined as a DOD of 50 % or a half of an available capacity of a battery cell.

A battery management method according to an embodiment disclosed herein includes calculating an available capacity of each of a plurality of battery cells, extracting a reference battery cell having a minimum available capacity among available capacities of the plurality of battery cells and setting the minimum available capacity as a reference capacity, setting a reference depth of discharge (DOD) that is a DOD value set in a random DOD range, calculating a first reference voltage corresponding to the reference DOD of the reference battery cell, and performing balancing on each of the plurality of battery cells based on the first reference voltage.

According to an embodiment, the battery management method may further include, before the performing of the balancing, determining whether a difference between a maximum available capacity and the minimum available capacity among the plurality of battery cells is greater than or equal to a preset value.

According to an embodiment, the performing of the balancing may include adjusting a cell voltage of each of the plurality of battery cells such that a comparative voltage corresponding to the reference DOD of each of the plurality of battery cells corresponds to the first reference voltage.

According to an embodiment, the performing of the balancing may include setting an operating voltage range of each of the plurality of battery cells such that an operating capacity of each of the plurality of battery cells corresponds to the reference capacity.

According to an embodiment, the performing of the balancing may include setting a modified state of charge (SOC) of each of the plurality of battery cells, based on the operating voltage range of each of the plurality of battery cells.

According to an embodiment, the plurality of battery cells may include a first battery cell and a second battery cell having an available capacity that is different from an available capacity of the first battery cell, and an operating voltage range of the first battery cell may be different from an operating voltage range of the second battery cell.

According to an embodiment, the available capacity of the first battery cell may be less than the available capacity of the second battery cell, and the operating voltage range of the first battery cell may include the operating voltage range of the second battery cell.

According to an embodiment, an operating capacity of each of the plurality of battery cells, which corresponds to the operating voltage, may be the same as each other.

According to an embodiment, the reference DOD may be defined as a DOD of 50 % or a half of an available capacity of a battery cell.

Specific details of other embodiments are included in the detailed description and drawings.

### [ADVANTAGEOUS EFFECTS]

The battery management apparatus and the operating method thereof according to embodiments disclosed herein may adjust an operating voltage range of a battery cell to manage an available capacity of each of a plurality of battery cells.

The battery management apparatus and the operating method thereof according to embodiments disclosed herein may adjust an operating voltage range of a battery cell to prevent over-charging and over-discharging of a battery cell and improve a lifetime of the battery cell.

The battery management apparatus and the operating method according to an embodiment disclosed herein may improve the lifetime of the battery by reducing the frequency of passive balancing.

The technical effects of the battery inspection apparatus and the operating method thereof according to embodiments disclosed in the present document are not limited to the effects mentioned above, and other effects not mentioned will be clearly understood by those of ordinary skill in the art according to the disclosure of the present document.

### [DESCRIPTION OF DRAWINGS]

FIG. 1 is a block diagram of a battery system according to an embodiment disclosed herein.
FIG. 2 is a view showing that a battery management apparatus according to an embodiment disclosed herein performs balancing on a plurality of battery cells.
FIG. 3 is a flowchart showing a cell balancing method according to an embodiment disclosed herein.
FIG. 4 is a flowchart showing in detail an operation of performing balancing on each of a plurality of battery cells based on a first reference voltage in FIG. 3.
FIG. 5 is a block diagram showing a computing system that performs a cell balancing method according to an embodiment disclosed herein.

With regard to the description of the drawings, identical reference numerals may be used to refer to identical or related elements.

### [MODE FOR INVENTION]

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. In the case of online distribution, at least a part of a computer program product may be at least temporarily stored in a machine-readable storage medium such as a memory of a server of a manufacturer, a server of an application store, or a relay server, or may be generated temporarily.

According to embodiments disclosed herein, each of the above-described components (e.g., a module or program) may include a single entity or a plurality of entities, some of which may be separately disposed on other components. According to embodiments disclosed herein, one or more of the above-described components or operations may be omitted, or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to embodiments disclosed herein, operations performed by a module, a program, or other components may be executed sequentially, in parallel, repeatedly, or heuristically, or one or more of the operations may be executed in a different order or omitted, or one or more other operations may be added.

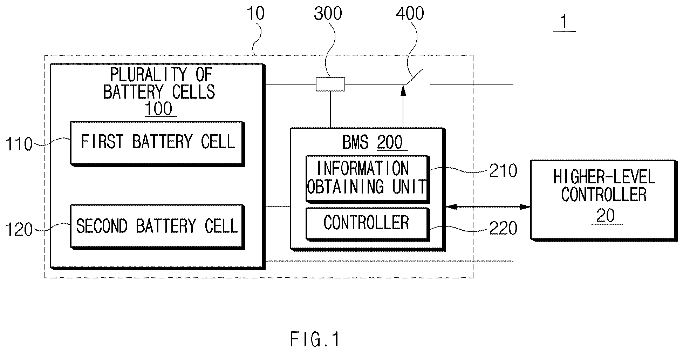

FIG. 1 is a block diagram of a battery system according to an embodiment disclosed herein.

Referring to FIG. 1, a battery system 1 may include a battery pack 10 and a higher-level controller 20.

The battery pack 10 may include a plurality of battery cells 100, a battery management apparatus 200, a sensor 300, and a switching unit 400. The plurality of battery cells 100 may be a set of battery cells including at least two battery cells. Each of the battery cells included in the plurality of battery cells 100 may be connected in series or in parallel with each other.

The plurality of battery cells 100 may include two or more battery cells. According to an embodiment, the plurality of battery cells 100 may include a first battery cell 110 and a second battery cell 120. Herein, the first battery cell 110 and the second battery cell 120 may be different battery cells.

The available capacities of the battery cells included in the plurality of battery cells 100 may be different from each other. Here, an available capacity may mean the amount of electrons that may be stored in a battery cell. According to an embodiment, degradation speeds of battery cells included in the plurality of battery cells 100 may be different from each other due to factors such as production deviation, temperature, voltage, etc. According to an embodiment, available capacities of battery cells included in the plurality of battery cells 100 may be different from each other due to a difference in degradation speed of each battery cell included in the plurality of battery cells 100.

The available capacities of the first battery cell 110 and the second battery cell 120 included in the plurality of battery cells 100 may be different from each other. Herein, the available capacity of the first battery cell 110 may be defined as a [Ah]. The available capacity of the second battery cell 120 may be defined as b [Ah]. a and b may be different from each other.

According to an embodiment, the available capacity of the first battery cell 110 may be less than the available capacity of the second battery cell 120. That is, the available capacity of the first battery cell 110, a [Ah], may be less than the available capacity of the second battery cell 120, b [Ah].

The battery management apparatus 200 may manage the battery pack 10. The battery management apparatus 200 may manage each of the plurality of battery cells 100 based on information of the plurality of battery cells 100. According to an embodiment, the battery management apparatus 200 may monitor a voltage, a current, a temperature, etc., of the battery pack 10 to prevent over-charging and over-discharging, etc. In addition, the battery management apparatus 200 may include, as an interface for receiving information about the plurality of battery cells 100, a plurality of terminals for receiving the information. Meanwhile, the battery management apparatus 200 may control ON/OFF of the switching unit 400 and may be connected to the plurality of battery cells 100 to monitor the state of each of the plurality of battery cells 100.

The battery management apparatus 200 may include an information obtaining unit 210 and a controller 220. Herein, the information obtaining unit 210 may obtain a current of each of the plurality of battery cells 100. Accordingly, the information obtaining unit 210 may obtain current information of the first battery cell 110 and current information of the second battery cell 120. According to an embodiment, the information obtaining unit 210 may be directly connected to the first battery cell 110 and the second battery cell 120 to obtain a current of the first battery cell 110 and the second battery cell 120 or may receive current information obtained by the sensor 300 from the sensor 300. The information obtaining unit 210 may transmit the current information of the plurality of battery cells 100 to the controller 220.

The controller 220 may calculate an available capacity of each of the plurality of battery cells 100. According to an embodiment, the controller 220 may calculate the available capacity of the battery cell based on the current information. That is, the controller 220 may calculate an available capacity of the first battery cell 110 based on current information of the first battery cell 110, received from the information obtaining unit 210, and calculate an available capacity of the second battery cell 120 based on current information of the second battery cell 120. According to an embodiment, the available capacity of the first battery cell 110 and the available capacity of the second battery cell 120, calculated by the controller 220, may be a [Ah] and b [Ah], respectively.

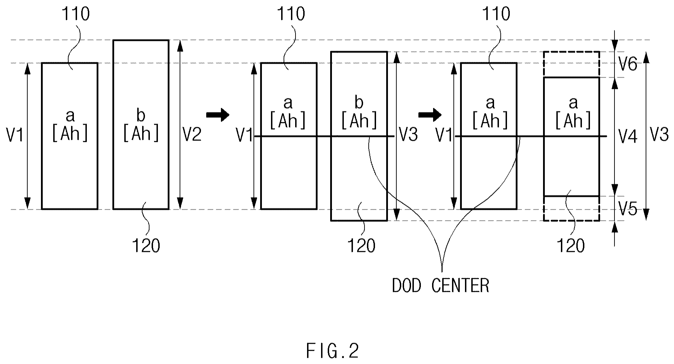

The controller 220 may perform balancing on the plurality of battery cells 100. That is, the controller 220 may perform balancing on the first battery cell 110 and the second battery cell 120. Balancing operations of the controller 220 will be described in detail with reference to FIG. 2.

The controller 220 may compare a difference between a maximum available capacity and a minimum available capacity of the plurality of battery cells 100 with a preset value. That is, the controller 220 may compare the available capacity of each of the plurality of battery cells 100 to select the maximum available capacity and the minimum available capacity. In addition, the controller 220 may calculate the maximum available capacity and the minimum available capacity. The controller 220 may compare the difference between the maximum available capacity and the minimum available capacity with the preset value. Herein, the preset value may be set based on the specifications of the battery cell included in the plurality of battery cells 100.

When the difference between the maximum available capacity and the minimum available capacity of the plurality of battery cells 100 is greater than or equal to the preset value, the controller 220 may perform cell balancing. When the difference between the maximum available capacity and the minimum available capacity is less than the preset value, the controller 220 may not perform cell balancing.

According to an embodiment, the controller 220 may provide a balancing result to a user. When performing balancing on the plurality of battery cells 100, the controller 220 may provide information related to balancing to the user. For example, the controller 220 may provide the information related to balancing to a user terminal through a communication unit (not shown) and also provide the information about balancing through a display provided in a vehicle, a charger, etc.

The sensor 300 may obtain the information about the plurality of battery cells 100. The sensor 300 may be connected to the plurality of battery cells 100 to obtain the information about the plurality of battery cells 100. The sensor 300 may transmit the information obtained from the plurality of battery cells 100 to the battery management apparatus 200. According to an embodiment, the sensor 300 may be the same component as the information obtaining unit 210 included in the battery management apparatus 200. According to an embodiment, the sensor 300 may be a component that obtains information that is different from that of the information obtaining unit 210.

The switching unit 400 may control a current flow of the plurality of battery cells 100. That is, the switching unit 400 may be connected to the plurality of battery cells 100 in series to a first terminal side and/or a second terminal side of the plurality of battery cells 100 to control a charging/discharging current flow of the battery cell 110. According to an embodiment, the switching unit 400 may include at least one relay, a magnetic contactor, etc., based on the specification of the battery pack 10.

The higher-level controller 20 may transmit a control signal regarding the battery cell 110 to the battery management apparatus 200. Thus, the battery management apparatus 200 may be controlled in terms of an operation thereof based on the control signal applied from the higher-level controller 20.

FIG. 2 is a view showing that a battery management apparatus according to an embodiment disclosed herein performs balancing on a plurality of battery cells.

Referring to FIG. 2, The controller 220 may perform balancing on the plurality of battery cells 100. That is, the controller 220 may perform balancing on the first battery cell 110 and the second battery cell 120. While cell balancing with respect to two battery cells (i.e., the first battery cell 110 and the second battery cell 120) is shown in FIG. 2, the following description may be substantially identically applied to cell balancing with respect to two or more battery cells.

The controller 220 may extract a reference battery cell having the minimum available capacity. That is, the controller 220 may compare the available capacity of each of the plurality of battery cells 100 to extract the reference battery cell having the minimum available capacity. For example, the reference battery cell having the minimum available capacity may be the first battery cell 110.

The controller 220 may define the available capacity of the reference battery cell as a reference capacity. Thus, the reference capacity may be defined as an available capacity of the first battery cell 110. For example, the reference capacity may be defined as a [Ah].

The controller 220 may also set the other battery cells than the reference battery cell among the plurality of battery cells 100 as target battery cells. For example, the target battery cells may include the second battery cell 120.

Hereinbelow, for convenience of a description, the reference battery cell may be assumed to be the first battery cell 110. The target battery cell may be assumed to be the second battery cell 120.

The controller 220 may set a reference depth of discharge (DOD) of the first battery cell 110. Herein, the reference DOD may refer to a DOD value set in a random DOD range of a battery cell, and may include, for example, a DOD value set at random by a user between 30 % to 70 %.

According to an embodiment, the reference DOD may be set to a center value of the available capacity. Herein, the center of the available capacity may be defined as a half of the available capacity of the battery cell. In this case, the reference DOD of the first battery cell 110 may be a/2 [Ah] that is a half of the available capacity of the first battery cell 110.

The controller 220 may obtain a first reference voltage corresponding to the reference DOD of the first battery cell 110. The controller 220 may also obtain a second reference voltage corresponding to the reference DOD of the second battery cell 120.

The controller 220 may perform balancing on each of the plurality of battery cells 100 based on the first reference voltage. The controller 220 may perform balancing on the second battery cell 120 by adjusting a cell voltage of the second battery cell 120 based on the first reference voltage of the first battery cell 110. Specifically, the controller 220 may perform balancing on the second battery cell 120 by sequentially adjusting the cell voltage of the second battery cell 120.

The controller 220 may primarily adjust the cell voltage of the second battery cell 120. The controller 220 may adjust the cell voltage of the second battery cell 120 such that the second reference voltage of the second battery cell 120 corresponds to the first reference voltage. That is, the controller 220 may primarily adjust the operating voltage range of the second battery cell 120 that is the target battery cell while maintaining the operating voltage range of the first battery cell 110 that is the reference battery cell. According to an embodiment, the operating voltage range may refer to a range from a voltage in a fully discharged state of the battery cell to a fully charged state of the battery cell. The operating voltage range of the first battery cell 110 may be defined as a first operating voltage range V1. The operating voltage range of the second battery cell 120 before primary voltage adjustment may be defined as a second operating voltage range V2. The operating voltage range of the second battery cell 120 after primary voltage adjustment may be defined as a third operating voltage range V3.

Herein, the primary voltage adjustment may be adjustment for changing the start and end of the operating voltage range while maintaining a size of the operating voltage range. That is, the size of the second operating voltage range V2 and the size of the third operating voltage range V3 are the same as each other, and the start of the third operating voltage range V3 is lower than that of the second operating voltage range V2, and the end of the third operating voltage range V3 may be lower than that of the second operating voltage range V2.

The controller 220 may maintain the first operating voltage range V1 and adjust the second operating voltage range V2 to the third operating voltage range V3 such that the second reference voltage of the second battery cell 120 corresponds to the first reference voltage. Thus, the reference DOD of the first battery cell 110 and the reference DOD of the second battery cell 120 may correspond to each other.

The controller 220 may secondarily adjust the operating voltage range of the second battery cell 120. The controller 220 may adjust the operating voltage range of the second battery cell 120 such that the available capacity of the second battery cell 120 corresponds to the available capacity of the first battery cell 110.

A voltage and a capacity of a battery cell correspond to each other, and thus the operating voltage range of the battery cell may correspond to the available capacity of the battery cell. Thus, the controller 220 may adjust the available capacity of the second battery cell 120 by adjusting the operating voltage range of the second battery cell 120. That is, the controller 220 may reduce the available capacity of the second battery cell 120 by narrowing the operating voltage range of the second battery cell 120.

The controller 220 may adjust the third operating voltage range V3 of the second battery cell 120 such that the available capacity of the second battery cell 120 corresponds to the available capacity of the first battery cell 110. That is, the controller 220 may narrow the third operating voltage range V3 of the second battery cell 120 such that the available capacity corresponding to the operating voltage range of the second battery cell 120 corresponds to the available capacity of the first battery cell 110.

That is, the controller 220 may narrow the operating voltage range of the second battery cell 120 such that the available capacity of the second battery cell 120, b [Ah], corresponds to the available capacity of the first battery cell 110, a [Ah].

Specifically, the controller 220 may limit an upper adjustment range V6 and a lower adjustment range V5 of the third operating voltage range V3 of the second battery cell 120 to narrow the third operating voltage range V3 of the second battery cell 120. For example, the controller 220 may increase the start point of the third operating voltage range V3 by the lower adjustment range V5 and decrease the end point of the third operating voltage range V3 by the upper adjustment range V6. According to an embodiment, a size of the upper adjustment range V6 and a size of the lower adjustment range V5 may be the same as each other, but the present disclosure is not limited thereto. According to an embodiment, a sum of the fourth operating voltage range V4, the lower adjustment range V5, and the upper adjustment range V6 may be equal to the third operating voltage range V3.

After secondary adjustment, the operating voltage range of the second battery cell 120 may be changed into the fourth operating voltage range V4. That is, the operating voltage range of the second battery cell 120 may be adjusted from the third operating voltage range V3 to the fourth operating voltage range V4 through secondary adjustment.

According to an embodiment, the fourth operating voltage range V4 may be different from the first operating voltage range V1. That is, the fourth operating voltage range V4, which is an operating voltage range of the second battery cell 120 after secondary adjustment, may be different from the first operating voltage range V1 that is the operating voltage range of the first battery cell 110. In other words, the available capacity of the second battery cell 120 after secondary adjustment of the second battery cell 120 may be equal to the available capacity of the first battery cell 110, but the fourth operating voltage range V4 may be different from the first operating voltage range V1. According to an embodiment, the first battery cell 110 and the second battery cell 120 may have different available capacities before voltage adjustment due to a difference in degradation speed, etc., such that the operating voltage ranges may not correspond to each other even when the available capacities correspond to each other through secondary adjustment of the second battery cell 120.

According to an embodiment, the first operating voltage range V1 may include the fourth operating voltage range V4. That is, the start point of the first operating voltage range V1 may be less than the start point of the fourth operating voltage range V4, and the end point of the first operating voltage range V1 may be greater than the end point of the fourth operating voltage range V4.

The controller 220 may control an operation of the second battery cell 120 such that the second battery cell 120 does not use capacities corresponding to the lower adjustment range V5 and the upper adjustment range V6 of the second battery cell 120 through secondary voltage adjustment. According to an embodiment, the controller 220 may control the second battery cell 120 such that a cell voltage of the second battery cell 120 does not fall beyond the start point of the fourth operating voltage range V4 even in case of full discharging. The controller 220 may adjust the second battery cell 120 such that the cell voltage of the second battery cell 120 does not fall beyond the end point of the fourth operating voltage range V4 even in case of full charging. Thus, the use frequencies of the fourth operating voltage range V4, the lower adjustment range V5, and the upper adjustment range V6 corresponding to the third operating voltage range V3 of the second battery cell 120 may be different.

In this way, the battery system 1 may reduce the use frequency of the upper part or the lower part of the operating voltage range of the battery cell and improve the use frequency of the voltage range corresponding to the middle part. Thus, it is possible to alleviate problems such as lifetime shortening of the battery cell, over-charging/over-discharging, etc., due to the frequency use of the upper part and the lower part of the battery cell. That is, the battery system 1 may improve the lifetime of the battery cell by adjusting the use frequency for each operating voltage of the battery.

According to an embodiment, the controller 220 may set a modified SOC. The controller 220 may set a modified SOC of each of the plurality of battery cells 100 based on an operating voltage range after balancing. The controller 220 may modify the SOC based on the operating voltage changed through primary cell voltage adjustment and secondary cell voltage adjustment, thus setting the modified SOC.

For example, before balancing on the second battery cell 120, an SOC in which the cell voltage of the second battery cell 120 corresponds to the start point of the second operating voltage range V2 is 0 %, and an SOC in which the cell voltage corresponds to the end point of the second operating voltage range V2 is 100 %.

The controller 220 may set the modified SOC of the second battery cell 120 after performing balancing on the second battery cell 120. The controller 220 may set the modified SOC based on the operating voltage range after balancing on the second battery cell 120. That is, the controller 220 may set the modified SOC to 0 % when the cell voltage of the second battery cell 120 corresponds to the start point of the fourth operating voltage range V4. The controller 220 may set the modified SOC to 100 % when the cell voltage of the second battery cell 120 corresponds to the end point of the fourth operating voltage range V4. That is, the controller 220 may modify the SOC based on the fourth operating voltage range V4 and set the modified SOC. According to an embodiment, the controller 220 may set a modified DOD in the same manner as setting the modified SOC.

The controller 220 may transmit the modified SOC to the user. According to an embodiment, the controller 220 may transmit the modified SOC to the user for each battery cell included in the plurality of battery cells 100 or calculate an average of the modified SOC of each of the plurality of battery cells 100 and transmit the average of the modified SOC to the user.

The battery system 1 may reduce the frequency of passive balancing. The battery system 1 may perform cell balancing with respect to a reference DOD of a battery cell having the minimum available capacity, thereby reducing the frequency of passive balancing. That is, the battery system 1 may use passive balancing only at primary voltage adjustment of each of the plurality of battery cells 100, thereby reducing the frequency of passive balancing. Thus, the battery system 1 may improve power efficiency by preventing power consumption according to passive balancing. Moreover, the battery system 1 may alleviate risk of heat generation and fire of the battery cell.

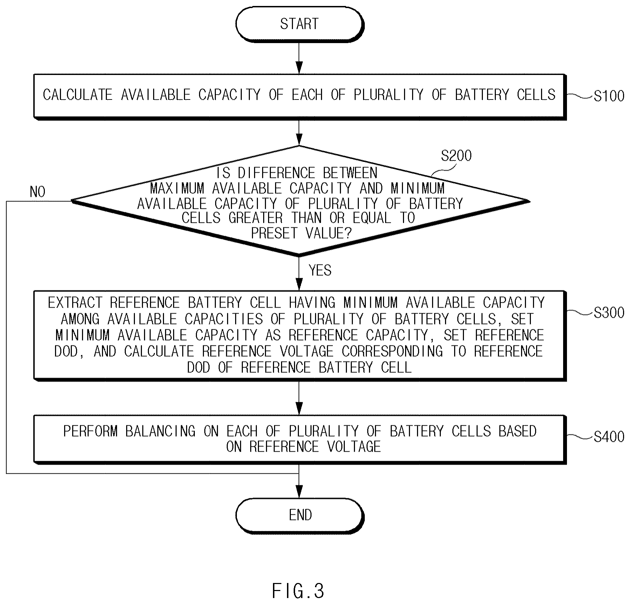

FIG. 3 is a flowchart showing a battery management method according to an embodiment disclosed herein.

An embodiment shown in FIG. 3 is merely an embodiment, and an order of operations according to various embodiments of the present disclosure may be different from that shown in FIG. 3, some operations shown in FIG. 3 may be omitted, or an order of the operations may be changed or operations may be merged.

Referring to FIG. 3, a battery management method may include operation S100 of calculating an available capacity of each of the plurality of battery cells 100, operation S200 of determining whether a difference between a maximum available capacity and a minimum available capacity of the plurality of battery cells 100 is greater than or equal to a preset value, operation S300 of extracting a reference battery cell having a minimum available capacity among the available capacities of the plurality of battery cells 100, setting the minimum available capacity as a reference capacity, setting a reference DOD, and calculating a first reference voltage corresponding to the reference DOD of the reference battery cell, and operation S400 of performing balancing on each of the plurality of battery cells 100 based on the first reference voltage.

Hereinbelow, operation S100 to S40 will be described in detail with reference to FIGS. 1 to 3.

In operation S100, the battery management apparatus 200 may calculate an available capacity of each of the plurality of battery cells 100. According to an embodiment, the battery management apparatus 200 may calculate the available capacity of each of the plurality of battery cells 100 based on current information of each of the plurality of battery cells 100.

In operation S200, the battery management apparatus 200 may determine whether a difference between the maximum available capacity and the minimum available capacity of the plurality of battery cells 100 is greater than or equal to a preset value.

The battery management apparatus 200 may compare the difference between the maximum available capacity and the minimum available capacity of the plurality of battery cells 100 with the preset value. That is, the battery management apparatus 200 may compare the available capacity of each of the plurality of battery cells 100 to select the maximum available capacity and the minimum available capacity. In addition, the battery management apparatus 200 may calculate the maximum available capacity and the minimum available capacity. The battery management apparatus 200 may compare the difference between the maximum available capacity and the minimum available capacity with the preset value. Herein, the preset value may be set based on the specifications of the battery cell included in the plurality of battery cells 100.

The battery management apparatus 200 may perform operation S300 when the difference between the maximum available capacity and the minimum available capacity is greater than or equal to the preset value. The battery management apparatus 200 may terminate the battery management method when the difference between the maximum available capacity and the minimum available capacity is less than the preset value.

In operation S300, the battery management apparatus 200 may extract the reference battery cell having the minimum available capacity among the available capacities of the plurality of battery cells 100, set the minimum available capacity as a reference capacity, set a reference DOD, and calculate a first reference voltage corresponding to the reference DOD of the reference battery cell.

The battery management apparatus 200 may extract the battery cell having the minimum available capacity. That is, the battery management apparatus 200 may compare the available capacity of each of the plurality of battery cells 100 to extract a battery cell having the minimum available capacity. Herein, the battery cell having the minimum available capacity may be defined as the reference battery cell.

The battery management apparatus 200 may set the reference capacity. According to an embodiment, the battery management apparatus 200 may define the capacity of the reference battery cell as the reference capacity. That is, the available capacity of the battery cell having the minimum available capacity may be defined as the reference capacity.

The battery management apparatus 200 may set a reference depth of discharge (DOD) of the reference battery cell. Herein, the reference DOD may be a DOD set at random by the user between a DOD of 30 % to a DOD of 70 %.

According to an embodiment, the user may set the center of the available capacity as the reference DOD. Herein, the center of the available capacity may be defined as a point at which the DOD of the battery cell is 50 % or a half of the available capacity of the battery cell.

The battery management apparatus 200 may calculate a voltage corresponding to the reference DOD of the reference battery cell. Herein, the voltage corresponding to the reference DOD of the reference battery cell may be defined as the first reference voltage.

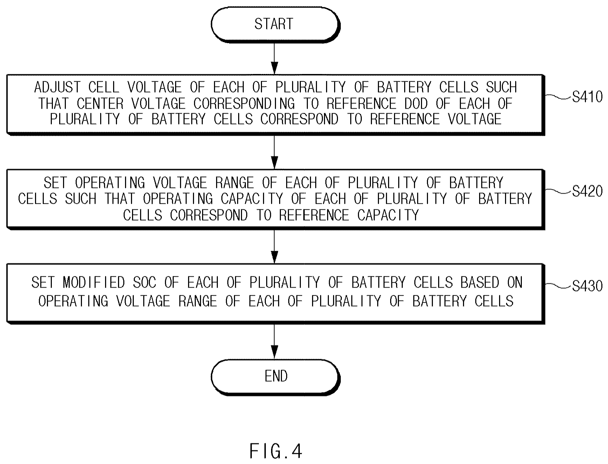

In operation S400, the battery management apparatus 200 may perform balancing on each of the plurality of battery cells 100 based on the first reference voltage. Herein, this will be described in detail with reference to FIG. 4.

FIG. 4 is a flowchart showing in detail an operation of performing balancing on each of the plurality of battery cells 100 based on a first reference voltage in FIG. 3.

Referring to FIG. 4, an operation of performing balancing on each of the plurality of battery cells 100 based on the first reference voltage may include operation S410 of adjusting a cell voltage of each of the plurality of battery cells 100 such that a second reference voltage corresponding to a reference DOD of each of the plurality of battery cells 100 corresponds to the first reference voltage, operation S420 of setting an operating voltage range of each of the plurality of battery cells 100 such that an operating capacity of each of the plurality of battery cells 100 corresponds to a reference capacity, and operation S430 of setting a modified SOC of each of the plurality of battery cells 100 based on the operating voltage range of each of the plurality of battery cells 100.

In operation S410, the battery management apparatus 200 may adjust a cell voltage of each of the plurality of battery cells 100 such that the second reference voltage corresponding to the reference DOD of each of the plurality of battery cells 100 corresponds to the first reference voltage.

The battery management apparatus 200 may primarily adjust the cell voltage of each of the plurality of battery cells 100. That is, the battery management apparatus 200 may adjust the cell voltage of each of the plurality of battery cells 100 such that the voltage corresponding to the reference DOD of each of the plurality of battery cells 100 corresponds to the first reference voltage. Specifically, the battery management apparatus 200 may perform passive balancing on each of the other battery cells than the reference battery cell among the plurality of battery cells 100 to adjust the cell voltage of each of the plurality of battery cells 100 such that the voltage corresponding to the reference DOD of each of the plurality of battery cells 100 corresponds to the first reference voltage. Herein, the voltage corresponding to the reference DOD of each of the plurality of battery cells 100 may be defined as the second reference voltage. In other words, the battery management apparatus 200 may adjust the cell voltage such that the second reference voltage of the plurality of battery cells 110 corresponds to the first reference voltage, by using passive balancing.

In operation S420, the battery management apparatus 200 may set the operating voltage range of each of the plurality of battery cells 100 such that the operating capacity of each of the plurality of battery cells 100 corresponds to the reference capacity.

The battery management apparatus 200 may secondarily adjust the cell voltages of the plurality of battery cells 100. The battery management apparatus 200 may adjust the voltage of each of the plurality of battery cells 100 such that the available capacity corresponding to each of the plurality of battery cells 100 corresponds to the available capacity of the reference battery cell. The reference battery cell may be a cell having the minimum available capacity among the plurality of battery cells 100, and thus the battery management apparatus 200 may adjust the available capacity by narrowing the operating voltage range of the plurality of battery cells 100. That is, the battery management apparatus 200 may reduce the available capacity of each of the plurality of battery cells 100 by narrowing the operating voltage range such that the available capacity of each of the plurality of battery cells 100 corresponds to the minimum available capacity.

Specifically, the battery management apparatus 200 may narrow the operating voltage range of the battery cell by limiting the upper adjustment range V6 and the lower adjustment range V5 of the operating voltage range of the battery cell. According to an embodiment, a size of the upper adjustment range V6 and a size of the lower adjustment range V5 may be the same as each other. Thus, the operating capacities of the battery cells included in the plurality of battery cells 100 may correspond to each other.

In operation S430, the battery management apparatus 200 may set a modified SOC of each of the plurality of battery cells 100 based on the operating voltage range of each of the plurality of battery cells 100.

The battery management apparatus 200 may set the modified SOC. The battery management apparatus 200 may set the modified SOC of each of the plurality of battery cells 100 based on an operating voltage range after balancing. The battery management apparatus 200 may modify the SOC based on the operating voltage changed through primary cell voltage adjustment and secondary cell voltage adjustment, thus setting the modified SOC.

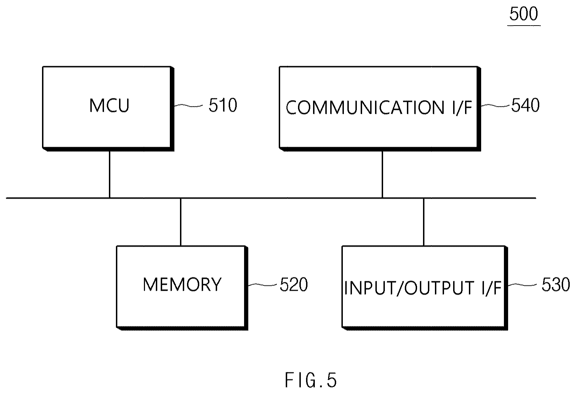

FIG. 5 is a block diagram showing a computing system that performs a battery management method according to an embodiment disclosed herein.

Referring to FIG. 5, a computing system 500 according to an embodiment disclosed herein may include a micro control unit (MCU) 510, a memory 520, an input/output I/F 530, and a communication I/F 540.

The MCU 510 may be a processor that executes various programs (e.g., an SOH calculation program, a cell balancing target determination program, etc.) stored in the memory 520, processes various data including an SOC, an SOH, etc., of the plurality of battery cells through these programs, and executes the above-described functions of the battery management apparatus 200 described with reference to FIGS. 1 to 3.

The memory 520 may store various programs regarding SOH calculation of the battery cell, cell balancing target determination, etc. Moreover, the memory 520 may store various data such as SOC data, SOH data, etc., of each battery cell.

The memory 520 may be provided in plural, depending on a need. The memory 520 may be volatile memory or non-volatile memory. For the memory 520 as the volatile memory, random access memory (RAM), dynamic RAM (DRAM), static RAM (SRAM), etc., may be used. For the memory 520 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 520 are merely examples and are not limited thereto.

The input/output I/F 530 may provide an interface for transmitting and receiving data by connecting an input device (not shown) such as a keyboard, a mouse, a touch panel, etc., and an output device such as a display (not shown), etc., to the MCU 510.

The communication I/F 540, which is a component capable of transmitting and receiving various data to and from a server, may be various devices capable of supporting wired or wireless communication. For example, a program for SOH calculation of the battery cell or balancing target determination or various data, etc., may be transmitted and received to and from a separately provided external server through the communication I/F 540.

As such, the battery management method according to an embodiment disclosed herein may be recorded in the memory 520 and executed by the MCU 510.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

### [EXPLANATION OF REFERENCE NUMERALS]

1: BATTERY SYSTEM
10: BATTERY PACK
100: PLURALITY OF BATTERY CELLS
110: FIRST BATTERY CELL
120: SECOND BATTERY CELL
210: INFORMATION OBTAINING UNIT
220: CONTROLLER

## Claims

1. A battery management apparatus comprising:
an information obtaining unit configured to measure a cell current of each of a plurality of battery cells; and
a controller configured to:
calculate an available capacity of each of the plurality of battery cells, based on the cell current;
extract a reference battery cell having a minimum available capacity among available capacities of the plurality of battery cells and set the minimum available capacity as a reference capacity;
set a reference depth of discharge (DOD) that is a DOD value set in a random DOD range;
calculate a first reference voltage corresponding to the reference DOD of the reference battery cell; and
perform balancing on each of the plurality of battery cells based on the first reference voltage.

2. The battery management apparatus of claim 1, wherein the controller is further configured to adjust a cell voltage of each of the plurality of battery cells such that a comparative voltage corresponding to the reference DOD of each of the plurality of battery cells corresponds to the first reference voltage.

3. The battery management apparatus of claim 1, wherein the controller is further configured to set an operating voltage range of each of the plurality of battery cells such that an operating capacity of each of the plurality of battery cells corresponds to the reference capacity.

4. The battery management apparatus of claim 3, wherein the plurality of battery cells comprise a first battery cell and a second battery cell having an available capacity that is different from an available capacity of the first battery cell, and
an operating voltage range of the first battery cell is different from an operating voltage range of the second battery cell.

5. The battery management apparatus of claim 4, wherein the available capacity of the first battery cell is less than the available capacity of the second battery cell, and
the operating voltage range of the first battery cell comprises the operating voltage range of the second battery cell.

6. The battery management apparatus of claim 3, wherein the controller is further configured to set a modified state of charge (SOC) of each of the plurality of battery cells, based on the operating voltage range of each of the plurality of battery cells.

7. The battery management apparatus of claim 3, wherein an operating capacity of each of the plurality of battery cells, which corresponds to the operating voltage, is the same as each other.

8. The battery management apparatus of claim 1, wherein the controller is further configured to perform balancing on each of the plurality of battery cells when a difference between a maximum available capacity and the minimum available capacity of the plurality of battery cells is greater than or equal to a preset value.

9. The battery management apparatus of claim 1, wherein the reference DOD is defined as a DOD of 50 % or a half of an available capacity of a battery cell.

10. A battery management method comprising:
calculating an available capacity of each of a plurality of battery cells;
extracting a reference battery cell having a minimum available capacity among available capacities of the plurality of battery cells and setting the minimum available capacity as a reference capacity;
setting a reference depth of discharge (DOD) that is a DOD value set in a random DOD range;
calculating a first reference voltage corresponding to the reference DOD of the reference battery cell; and
performing balancing on each of the plurality of battery cells based on the first reference voltage.

11. The battery management method of claim 10, further comprising, before the performing of the balancing, determining whether a difference between a maximum available capacity and the minimum available capacity among the plurality of battery cells is greater than or equal to a preset value.

12. The battery management method of claim 10, wherein the performing of the balancing comprises adjusting a cell voltage of each of the plurality of battery cells such that a comparative voltage corresponding to the reference DOD of each of the plurality of battery cells corresponds to the first reference voltage.

13. The battery management method of claim 12, wherein the performing of the balancing comprises setting an operating voltage range of each of the plurality of battery cells such that an operating capacity of each of the plurality of battery cells corresponds to the reference capacity.

14. The battery management method of claim 13, wherein the performing of the balancing comprises setting a modified state of charge (SOC) of each of the plurality of battery cells, based on the operating voltage range of each of the plurality of battery cells.

15. The battery management method of claim 12, wherein the plurality of battery cells comprise a first battery cell and a second battery cell having an available capacity that is different from an available capacity of the first battery cell, and
an operating voltage range of the first battery cell is different from an operating voltage range of the second battery cell.

16. The battery management method of claim 15, wherein the available capacity of the first battery cell is less than the available capacity of the second battery cell, and
the operating voltage range of the first battery cell comprises the operating voltage range of the second battery cell.

17. The battery management method of claim 15, wherein an operating capacity of each of the plurality of battery cells, which corresponds to the operating voltage, is the same as each other.

18. The battery management method of claim 10, wherein the reference DOD is defined as a DOD of 50 % or a half of an available capacity of a battery cell.
